Europäisches Patentamt

European Patent Office

Office européen des brevets

(19)

(11) **EP 1 258 992 B1**

(12) **FASCICULE DE BREVET EUROPEEN**

(45) Date de publication et mention
de la délivrance du brevet:
**10.08.2005 Bulletin 2005/32**

(51) Int Cl.⁷: **H03M 1/06**
// H03M1/42

(21) Numéro de dépôt: **02291214.1**

(22) Date de dépôt: **16.05.2002**

(54) **Convertisseur analogique / numérique**

Analog-Digital-Wandler

Analogue-to-digital converter

(84) Etats contractants désignés:
**CH DE FR GB LI**

(30) Priorité: **18.05.2001 FR 0106585**

(43) Date de publication de la demande:
**20.11.2002 Bulletin 2002/47**

(73) Titulaire: **CSEM**
**Centre Suisse d'Electronique et de**
**Microtechnique SA Recherche et**
**Développement**
**2007 Neuchâtel (CH)**

(72) Inventeur: **Heim, Pascal**
**2022 Bevaix (CH)**

(74) Mandataire: **Caron, Gérard**
**Cabinet JP Colas**
**37 avenue Franklin D. Roosevelt**
**75008 Paris (FR)**

(56) Documents cités:
**EP-A- 1 001 534**

• **PATENT ABSTRACTS OF JAPAN vol. 2000, no.**
**05, 14 septembre 2000 (2000-09-14) & JP 2000**
**049610 A (HITACHI LTD;HITACHI ULSI**
**SYSTEMS CO LTD), 18 février 2000 (2000-02-18)**

## Description

La présente invention est relative à un convertisseur analogique/numérique réalisé de préférence en technologie C-MOS, tel que défini par le préambule de la revendication 1.

Le document EP 1 001 534 décrit un convertisseur anatogique-numérique comprenant une entrée variable Vin qui est comparée à un signal de référence fixe Vref. Ce convertisseur est composé d'une cascade de cellules comprenant chacune un circuit de seuillage et un comparateur. Le circuit de seuillage compare le signal d'entrée Vin à un niveau de tension de référence prédéterminé qui dépend du rang de la cellule, et délivre en sortie un signal de tension décalé en fonction du résultat de la comparaison. Le comparateur définit la valeur binaire associée à la cellule en fonction du signal de différence, et commande le niveau de tension de référence utilisé dans la cellule suivante en fonction de la valeur binaire ainsi déterminée. Ce circuit nécessite toutefois plusieurs signaux de tension de référence (VREF, LEVEL1, LEVEL2) ainsi que plusieurs signaux (REFRESH, CLK3, CLK2, CLK1, CLK0) de commande et de synchronisation des différentes cellules.

L'invention a pour but de fournir un convertisseur du type générique défini ci-dessus et présentant une structure simple et en outre une faible consommation.

L'invention a ainsi pour objet un convertisseur analogique/numérique tel que défini dans la revendication 1.

Grâce aux caractéristiques ainsi définies, le convertisseur peut être composé de cellules de structure identique et chaque cycle de conversion peut être initié moyennant un seul signal de déclenchement. En outre, le temps de conversion nécessaire à l'obtention de chaque mot binaire est proportionnel au nombre de bits de ce mot.

D'autres particularités intéressantes de l'invention sont définies dans les sous-revendications.

D'autres caractéristiques et avantages de la présente invention apparaîtront au cours de la description qui va suivre, donnée uniquement à titre d'exemple et faite en se référant aux dessins annexés sur lesquels:

- la figure 1 est un schéma simplifié d'un convertisseur analogique/numérique conçu selon le mode de réalisation préféré de l'invention;
- la figure 2 est un diagramme des temps illustrant le fonctionnement du convertisseur analogique/numérique représenté sur la figure 1;
- la figure 3 est un schéma d'un circuit d'échantillonnage et de comparaison utilisé de préférence dans le convertisseur de la figure 1;
- la figure 4 est un schéma équivalent de ce circuit d'échantillonnage et de comparaison pour en illustrer le fonctionnement; et
- la figure 5 est un schéma fonctionnel illustrant également le fonctionnement d'une partie du circuit représenté sur les figures 3 et 4.

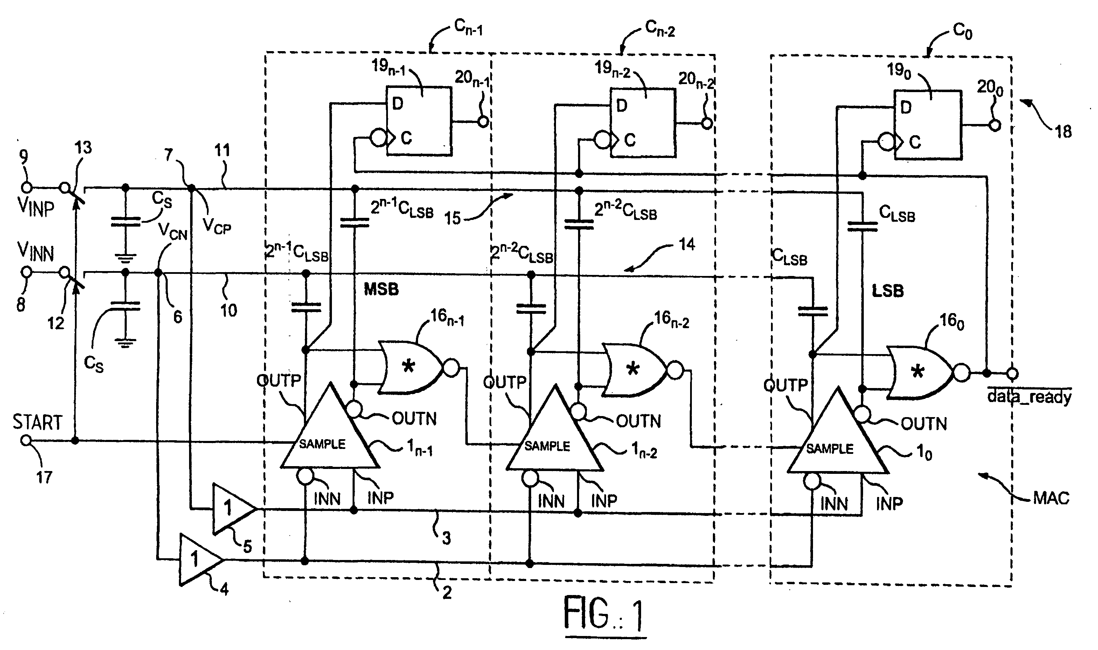

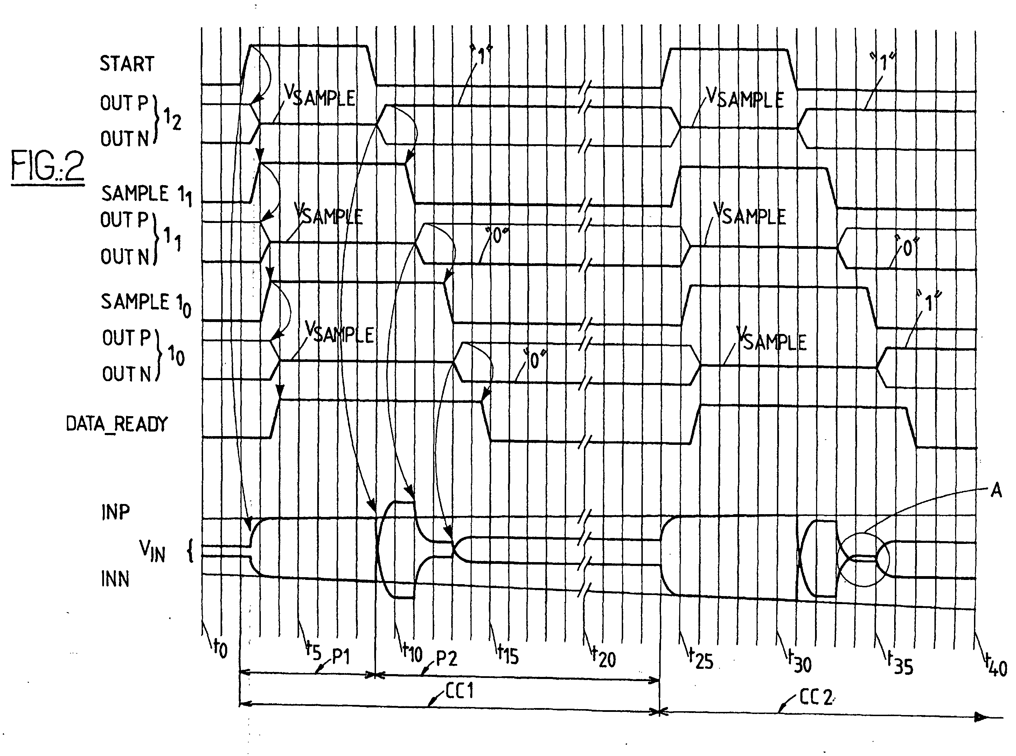

On va maintenant décrire le mode de réalisation préféré du convertisseur selon l'invention en se référant aux figures 1 et 2.

Ce convertisseur analogique/numérique comprend n cellules $C_0$ ... $C_{n-2}$, $C_{n-1}$, le nombre n définissant la résolution binaire c'est à dire le nombre de bits avec lequel la valeur analogique d'entrée peut être exprimée. Le convertisseur comprend également des moyens d'analyse et de commande MAC comportant dans chaque cellule un circuit d'échantillonnage et de comparaison. Ces circuits sont désignés respectivement par les références $1_0$ ... $1_{n-2}$, $1_{n-1}$. La cellule $C_0$ est celle qui a le rang le plus faible parmi les n cellules et elle fournit le bit LSB de poids le plus faible. La cellule $C_{n-1}$, au contraire, est celle qui a le rang le plus élevé parmi les n cellules et elle fournit le bit MSB de poids le plus fort. Chaque cellule comprend deux entrées INN, INP et deux sorties OUTN et OUTP. Dans l'exemple décrit, celles-ci sont formées respectivement par les entrées et les sorties du circuit d'échantillonnage et de comparaison de la cellule considérée. En outre, chaque circuit d'échantillonnage et de comparaison comprend une entrée de commande SAMPLE.

Les entrées INN et INP des circuits d'échantillonnage et de comparaison $1_0$ à $1_{n-1}$ de toutes les cellules $C_0$ à $C_{n-1}$ sont respectivement raccordées en parallèle à des lignes de connexion 2 et 3 qui, par l'intermédiaire de suiveurs (ou amplificateurs de gain unitaire) 4 et 5, sont reliées à des noeuds d'entrée 6 et 7 sur lesquels sont présents des potentiels respectifs $V_{CN}$ et $V_{CP}$.

Le signal analogique d'entrée à convertir est appliqué, en mode différentiel, à des bornes d'entrée 8 et 9 sur lesquelles sont présentes respectivement les composantes différentielles $V_{INN}$ et $V_{INP}$ de ce signal. Si ce dernier ne se présente pas en mode différentiel, il convient de prévoir un circuit d'adaptation adéquat (non représenté) connu des spécialistes par l'intermédiaire duquel le signal analogique en mode direct sera transformé en un signal en mode différentiel.

Les bornes d'entrée 8 et 9 sont raccordées respectivement à deux lignes 10 et 11 par l'intermédiaire d'interrupteurs 12 et 13. Les lignes 10 et 11 font partie de deux bancs de capacités 14 et 15 respectifs. Ces bancs de capacités comprennent chacun des capacités $C_S$, et $C_{LSB}$ à $2^{n-1}C_{LSB}$. L'une des armatures de chacune de ces capacités est connectée à la ligne respective 10 ou 11.

Les autres armatures des capacités $C_S$ sont reliées à la masse. Chaque cellule $C_0$ à $C_{n-1}$ comprend deux capacités, de valeur égale, dont les armatures opposées aux lignes 10 et 11 sont raccordées aux sorties respectives OUTP et OUTN des circuits d'échantillonnage et de comparaison $1_0$ à $1_{n-1}$. Dans chaque banc de capacités 14 et 15, les valeurs des capacités augmentent chaque fois d'un facteur 2 en allant de la capa-

cité de la cellule $C_0$ à la capacité de la cellule $C_{n-1}$.

Les suiveurs 4 et 5 servent à isoler les bancs de capacités 14 et 15 des capacités parasites présentes sur les bornes d'entrée INN et INP des circuits d'échantillonnage et de comparaison $1_0$ à $1_{n-1}$. Ils peuvent éventuellement être omis si ces capacités parasites sont faibles ou si on peut se contenter d'une faible résolution de la conversion analogique/numérique.

Les sorties OUTN et OUTP des circuits d'échantillonnage et de comparaison $1_0$ à $1_{n-1}$ sont raccordées à des moyens de combinaison logique de type OU formés dans le présent exemple par des portes NOR correspondantes $16_0$ à $16_{n-1}$. L'entrée SAMPLE du circuit d'échantillonnage et de comparaison $1_{n-1}$ de la cellule $C_{n-1}$ est connectée à une borne de déclenchement 17 à laquelle peut être appliqué un signal START de démarrage de chaque cycle de conversion. Ce signal peut être présenté à une fréquence de l'ordre de 5 MHz par exemple, cette valeur n'étant donnée que pour fixer les idées.

Les entrées SAMPLE des circuits d'échantillonnage et de comparaison $1_0$ à $1_{n-2}$ de toutes les autres cellules $C_0$ à $C_{n-2}$ sont raccordées respectivement à la sortie de la porte NOR $16_1$ à $16_{n-1}$ de la cellule dont le rang est immédiatement supérieur à celui de la cellule considérée.

L'une des sorties, en l'occurrence la sortie OUTP, de chaque circuit d'échantillonnage et de comparaison est en outre raccordée à un registre de sortie 18 composé de n bascules D $19_0$ à $19_{n-1}$. Les entrées d'horloge C de ces bascules sont raccordées en commun à la sortie de la porte NOR $16_0$ sur laquelle apparaît le complément d'un signal DATA_READY. Les entrées d'horloge des bascules D sont inversées, de sorte que celles-ci basculent sur le flanc descendant du complément du signal DATA_READY. Les sorties $20_0$ à $20_{n-1}$ des bascules D $19_0$ à $19_{n-1}$ fournissent ensemble le mot binaire préparé par le convertisseur pendant le cycle de conversion qui vient de s'achever.

Le fonctionnement de ce convertisseur sera maintenant examiné en faisant référence au diagramme des temps de la figure 2. Sur cette figure, on a supposé à titre d'exemple et pour simplifier que le convertisseur effectue une conversion sur 3 bits et ne comporte donc que trois cellules de rangs 0, 1 et 2. Cependant, il est évident que l'on peut prévoir un nombre quelconque de cellules en fonction de la résolution binaire que l'on souhaite obtenir. En outre, le diagramme illustre seulement deux cycles de conversion CC1 et CC2 successifs s'étendant respectivement de l'instant t2 à l'instant t24 et de l'instant t24 à un instant situé au-delà de l'instant t40, non visible sur le diagramme. Chaque cycle de conversion CC1, CC2 est divisé en deux phases, une première phase P1 dite d'"échantillonnage" et une seconde phase P2 dite de "comparaison".

La conversion s'effectue en cascade en passant de la cellule $C_2$ du bit MSB à la cellule $C_0$ du bit LSB.

Lorsque au temps t2, le signal START passe à "1", les sorties OUTN et OUTP du circuit d'échantillonnage et de comparaison $1_2$ sont d'abord court-circuitées, cette action résultant du fonctionnement de ce circuit qui est encore à décrire.

Le potentiel de ces deux sorties s'établit alors à une valeur $V_{SAMPLE}$ de sorte que la porte NOR $16_2$ voit ses deux entrées portées à la valeur "0". De ce fait, au temps $t_3$ la sortie de cette porte NOR $16_2$ passe à "1". Au même instant, le circuit d'échantillonnage et de comparaison $1_1$ passe en mode d'échantillonnage et les sorties OUTN et OUTP sont portées au potentiel $V_{SAMPLE}$. Le même processus se déroule ainsi en cascade pour la dernière cellule $C_0$. Il en résulte que les armatures de toutes les capacités des deux bancs 14 et 15 connectées aux sorties OUTP et OUTN se trouvent au potentiel $V_{SAMPLE}$.

Dans le même temps, le signal d'entrée $V_{IN}$, représenté par ses composantes différentielles $V_{INN}$ et $V_{INP}$, est échantillonné sur les bancs de capacités 14 et 15 qui représentent en fait, chacun, une capacité respective $C_{INN}$, respectivement $C_{INP}$, constituée par la somme des capacités du banc respectif 14 ou 15 selon l'expression:

$$C_{INN} = C_{INP} = C_S + \left(2^n - 1\right)C_{LSB}$$

Tant que le signal START est maintenu à "1", le convertisseur reste en phase d'échantillonnage P1. Dans l'exemple de la figure 2, la seconde phase de conversion P2 peut donc commencer au temps t9, lorsque le signal START passe à "0".

Dans l'exemple de la figure 2, il est supposé que le signal $V_{IN}$ est croissant. Les signaux d'entrée INN et INP reflètent les valeurs correspondantes des signaux $V_{CN}$ et $V_{CP}$ présents sur les noeuds 6 et 7. Les valeurs des signaux INN et INP sont telles que le circuit 12 bascule en fournissant un "1" sur sa sortie OUTP et par conséquent un "0" sur sa sortie OUTN. Le bit MSB de la valeur convertie sera donc un "1" qui est appliqué à l'entrée D de la bascule $19_2$ (voir la deuxième ligne du diagramme de la figure 2).

Simultanément, il se produit une inversion de polarité sur les noeuds 6 et 7, les valeurs des tensions $V_{CP}$ et $V_{CN}$ étant majorées des potentiels induits, respectivement, par les capacités connectées sur les sorties OUTN et OUTP du circuit d'échantillonnage et de comparaison $1_2$.

Le circuit d'échantillonnage et de comparaison $1_2$ ayant basculé, la porte NOR $16_2$ reçoit désormais des signaux de niveaux logiques différents sur ses entrées de sorte que le signal SAMPLE du circuit d'échantillonnage et de comparaison $1_1$ passe à "0", initiant ainsi la comparaison, par ce dernier des nouvelles valeurs des signaux INN et INP. Ces valeurs sont telles (dans l'exemple) que le circuit d'échantillonnage et de comparaison $1$ bascule de manière à fournir un niveau "0" sur sa sortie OUTP et un niveau "1" sur sa sortie OUTN. Par conséquent, la valeur du bit intermédiaire sera "0" transmis sur la bascule D $19_1$. Le niveau "0" fourni par le circuit d'échantillonnage et de comparaison $1_1$ est visible sur la quatrième ligne du diagramme de la figure 2.

La porte NOR $16_1$ recevant désormais des signaux différents sur ses entrées, elle bascule peu après le temps $t_{12}$, ce qui démarre la conversion pour la dernière cellule $C_0$ du convertisseur. Dans ce cas, le circuit d'échantillonnage et de comparaison $1_0$ bascule également de manière à fournir un "0" sur sa sortie OUTP en raison de la redistribution sur les capacités des valeurs des tensions $V_{INP}$ et $V_{INN}$ majorées des valeurs respectives des signaux présents aux sorties OUTP et OUTN du circuit d'échantillonnage et de comparaison $_1$. Cette valeur de niveau "0" est visible à la $6^{ième}$ ligne du diagramme de la figure 2. La valeur "0", résultat de la dernière conversion, est appliquée à l'entrée D de la bascule $19_0$.

Le cycle de conversion CC1 étant ainsi achevé au niveau du dernier circuit d'échantillonnage et de comparaison $1_0$, la porte NOR $16_0$ bascule ramenant son signal de sortie (DATA_READY) à "0". De la sorte, la valeur convertie du cycle de conversion CC1 qui vient d'être décrit apparaît aux sorties des bascules D $19_0$ à $19_2$. En l'occurrence, cette valeur est "100".

Le cycle de conversion CC2 suivant commence au temps $t_{24}$, lorsque le signal START prend de nouveau la valeur "1". D'abord, les valeurs actuelles des signaux $V_{INN}$ et $V_{INP}$ sont échantillonnées comme pendant le cycle de conversion précédent et les portes NOR $16_0$ à $16_2$ transmettent le signal SAMPLE d'un circuit d'échantillonnage et de comparaison à l'autre.

La conversion commence au temps t31, lorsque le signal START prend de nouveau la valeur "0". Ensuite, dans le présent exemple les deux premières conversions donnent des résultats identiques (voir les valeurs "1" et "0" sur les deuxième et quatrième lignes du diagramme de la figure 2). Cependant, comme les valeurs des signaux $V_{INN}$ et $V_{INP}$ ont évolué en sens contraires, pendant la dernière conversion juste avant le temps t35, le circuit d'échantillonnage et de comparaison $1_0$ bascule dans le sens opposé par rapport à celui dans lequel il a basculé au cours du cycle de conversion précédent CC1 (voir les portions de courbe entourées d'un cercle A sur la figure 2). Par conséquent, la valeur binaire globale obtenue par le cycle de conversion est "101", cette valeur sortant des bascules $19_0$ à $19_2$, lorsque le signal DATA_READY apparaît à la sortie de la porte NOR $16_0$.

Il est à noter que, d'une façon générale, l'utilisation des portes NOR permet de rendre optimal le temps total de conversion. En effet, la charge capacitive aux sorties des circuits d'échantillonnage et de comparaison $1_0$ à $1_{n-1}$ étant différente dans chaque cellule, il est possible, en conférant aux portes NOR un seuil de basculement élevé, de s'adapter au transitoire de chacun de ces circuits. Le seuil des portes NOR se situe donc de préférence à une valeur $V_{SEUIL}$ supérieure à la valeur $V_{SAMPLE}$, comme montré dans la phase d'échantillonnage P1 du premier cycle de conversion CC1 représenté sur la figure 2.

Selon une première variante de l'invention qui s'applique en particulier, lorsque la vitesse de conversion n'est pas une exigence critique, il est possible de remplacer les moyens de combinaison logique formés par les portes NOR $16_0$ à $16_{n-1}$ par des circuits à retard connectés respectivement entre les entrées SAMPLE de chaque paire contiguë de circuits d'échantillonnage et de comparaison. Dans ce cas, il est avantageux pour ne pas ralentir le temps de conversion, que les délais introduits par ces circuits à retard ne courent qu'à partir du flanc descendant du signal START ou SAMPLE provenant, selon le cas, du circuit d'échantillonnage et de comparaison ayant travaillé précédemment dans un cycle de conversion. Par ailleurs, les délais doivent être suffisamment longs pour permettre au circuit d'échantillonnage et de comparaison associé de transiter, étant entendu que le circuit correspondant au bit MSB présente le temps de transition le plus long.

Selon une autre variante de l'invention, les moyens de ré-injection formés par les bancs de capacités peuvent être remplacés par des réseaux de résistances ou de conductances permettant de redistribuer les tensions dans chaque cellule sur les entrées des circuits d'échantillonnage et de comparaison après chaque conversion.

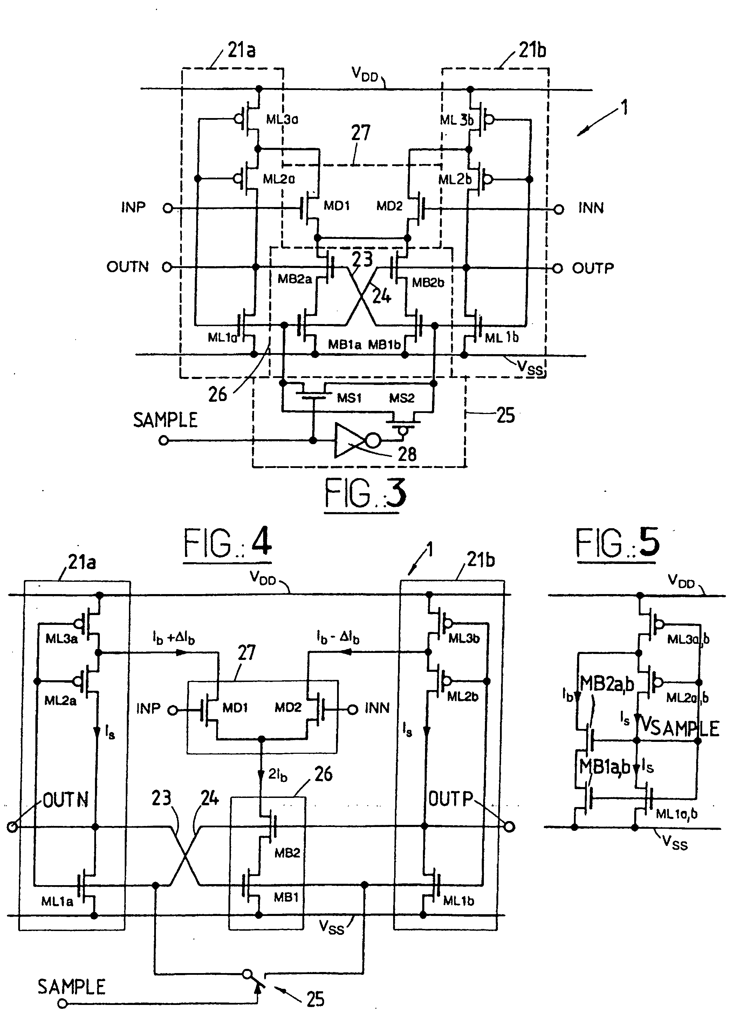

La figure 3 représente un schéma d'un exemple de circuit d'échantillonnage et de comparaison du type CMOS pouvant être utilisé avantageusement dans le convertisseur analogique/numérique de l'invention.

Ce circuit d'échantillonnage et de comparaison est désigné globalement par la référence 1. Il comprend cinq unités fonctionnelles à savoir des premier et second inverseurs 21a et 21b qui sont rebouclés l'un sur l'autre par des connexions croisées 23 et 24, un interrupteur d'échantillonnage 25, une source de courant 26 et une unité de comparaison 27.

Chaque inverseur 21a et 21b comprend deux transistors p, ML3a, ML2a, respectivement ML3b, ML2b et un transistor n, ML1a, respectivement ML1b, les trajets source-drain de ces transistors étant connectés en série entre des lignes d'alimentation $V_{DD}$ et $V_{SS}$. Dans chaque inverseur 21a et 21b, les grilles de ces transistors sont connectées ensemble.

L'unité de comparaison 27 comprend deux transistors n MD1 et MD2 dont les drains sont interconnectés et dont les sources sont respectivement reliées à des noeuds situés entre le drain du transistor ML3a, respectivement ML3b, et la source du transistor ML2a, respectivement ML2b. Ces noeuds sont appelés "entrées de déséquilibrage" de l'inverseur respectif. Les grilles des transistors MD1 et MD2 constituent, respectivement, les entrées INP et INN du circuit d'échantillonnage et de comparaison 1.

Les noeuds entre les transistors ML1a, ML2a et ML1b, ML2b constituent, respectivement, les sorties OUTN et OUTP du circuit.

La source de courant 26 comprend quatre transistors n MB1a, MB2a et MB1b, MB2b connectés, par paire, en série entre la ligne $V_{SS}$ et la connexion commune des transistors MD1 et MD2 de l'unité de comparaison 27. Les grilles des transistors MB1a, et MB2b sont connectées ensemble par l'intermédiaire de l'une des connexions croisées 24, le noeud correspondant étant également relié à la grille du transistor ML1a et à la borne de sortie OUTP.

De même, les grilles des transistors MB2a, et MB1b sont connectées ensemble par l'intermédiaire de l'autre connexion croisée 23, le noeud correspondant étant également relié à la grille du transistor ML1b et à la borne de sortie OUTN.

L'interrupteur d'échantillonnage 25 comprend un transistor n MS1 et un transistor p MS2 dont les trajets source-drain sont reliés en parallèle. La grille du transistor MS1 est connectée à une entrée de commande d'échantillonnage SAMPLE à laquelle est également reliée la grille du transistor MS2 par l'intermédiaire d'un inverseur 28.

Le schéma de la figure 4 est un circuit équivalent quelque peu simplifié du circuit d'échantillonnage et de comparaison 1. On y retrouve les cinq unités représentées sur la figure 3.

Pendant la phase d'échantillonnage P1, l'interrupteur 25 est fermé par le signal SAMPLE, les transistors MS1 et MS2 étant rendus conducteurs. Les deux sorties OUTN et OUTP sont alors portées au potentiel $V_{sample}$ de ce signal, moyennant quoi le circuit est maintenu en équilibre instable. Un courant de polarisation $21_b$ est établi dans les transistors MB1 et MB2 aux grilles desquels est présente la tension $V_{sample}$. Le déséquilibre du circuit 1 est alors établi en fonction de la différence $V_{in}$ des potentiels $V_{INP}$ et $V_{INN}$ présents, respectivement, sur les entrées INP et INN, des courants différents $I_b+\Delta I_b$ et $I_b-\Delta I_b$ étant envoyés, respectivement, dans les inverseurs 21a et 21b par une répartition différente du courant $2I_b$.

Dès que le signal de commande d'échantillonnage SAMPLE change de niveau, la réaction positive du circuit 1 va renforcer le déséquilibre ainsi créé pour faire finalement basculer le circuit. Dans l'état basculé, les deux sorties OUTN et OUTP sont complémentaires, leur niveau dépendant de la différence des signaux appliqués aux entrées INP et INN. Le courant de polarisation de la paire différentielle de transistors MD1 et MD2 est annulé car, en fonction des signaux d'entrée INN et INP, l'un ou l'autre des transistors MB1 ou MB2 a sa grille portée au potentiel $V_{SS}$.

Le circuit d'échantillonnage et de comparaison 1 est alors verrouillé, seul un nouveau signal SAMPLE pouvant déclencher la comparaison suivante.

Le circuit d'échantillonnage et de comparaison 1 qui vient d'être décrit ne consomme pas de courant dans l'état verrouillé et est extrêmement simple puisqu'il peut être réalisé avec quatorze transistors seulement.

Un autre avantage de ce circuit résulte de la représentation schématique de la figure 5 où on voit représenté un miroir de courant formé dans chaque inverseur respectivement par le transistor ML1a (ou ML1b) en entrée de miroir et par les transistors MB1a (ou MB1b) et MB2a (ou MB2b). Dans ce montage, le courant $I_b$ présente un rapport avec le courant $I_s$ circulant entre les transistors ML1a,b et ML2a,b qui est uniquement déterminé par le rapport géométrique du transistor ML1a,b et de la combinaison des transistors MB1 et MB2 se trouvant en sortie du miroir de courant. Ainsi, le rapport des courants peut facilement être déterminé par un dimensionnement adéquat des transistors concernés. En particulier, on s'assurera que la contre-réaction résultant de la correction appliquée au travers des capacités soit inférieure à la réaction positive des deux inverseurs rebouclés.

## Revendications

1. Convertisseur analogique/numérique destiné, au cours de cycles de conversion successifs (CC1, CC2), à convertir un signal analogique d'entrée en une succession de mots binaires comprenant chacun n bits, qui comprend:

   - au moins un noeud d'entrée (6, 7),
   - n cellules de conversion ($C_0$ à $C_{n-1}$),
   - un registre de sortie (18) comprenant n entrées (D) dont chacune est connectée à une sortie de l'une respective desdits cellules ($C_0$ à $C_{n-1}$) et aux sorties ($20_0$ à $20_{n-1}$) duquel sont fournis lesdits mots binaires, et
   - des moyens d'analyse et de commande (MAC) repartis sur lesdites n cellules,

     **caractérisé en ce que**

   - ledit signal analogique d'entrée se présente en mode différentiel sous forme de deux signaux d'entrée variables ($V_{INN}$, $V_{INP}$),
   - ledit convertisseur analogique/numérique comprend deux noeuds d'entrée (6, 7) sur lesquels, au cours d'une première phase (P1) de chaque cycle (CC1, CC2), sont appliquées respectivement les deux signaux d'entrée,
   - lesdites n cellules de conversion comprennent chacune deux entrées (INN, INP) et deux sorties (OUTN, OUTP),
   - ledit convertisseur analogique/numérique comprend des moyens de ré-injection (14, 15) repartis sur lesdites n cellules,

     lesdits moyens d'analyse et de commande (MAC) étant agencés pour, pendant ladite première phase (P1), activer successivement chacune desdites cellules ($C_0$ à $C_{n-1}$) afin d'échantillonner sur lesdites entrées (INN, INP) les potentiels régnant respectivement sur lesdits noeuds d'entrée (6, 7) et pour, pendant une seconde phase (P2) de chaque cycle de conversion (CC1, CC2), comparer successivement les potentiels régnant sur lesdits noeuds d'entrée (6, 7), tout en désactivant successivement lesdites cellules, lesdits moyens d'analyse et de commande (MAC) étant également agencés pour imposer des niveaux logiques résultant de la comparaison et correspondant à des valeurs binaires opposées sur lesdites sorties (OUTN, OUTP) desdites cellules, et

lesdits moyens de ré-injection (14, 15) étant agencés pour, à la suite de la comparaison effectuée dans chaque cellule, ré-injecter dans lesdits noeuds d'entrée (6, 7) lesdits niveaux logiques des deux sorties de cette cellule résultant de la comparaison dans cette cellule, la ré-injection étant pondérée en fonction du rang (0 à n-1) qu'occupe chaque cellule parmi lesdites n cellules ($C_0$ à $C_{n-1}$).

2. Convertisseur suivant la revendication 1, **caractérisé en ce que** lesdits moyens d'analyse et de commande (MAC) comprennent dans chacune desdites n cellules ($C_0$ à $C_{n-1}$), un circuit d'échantillonnage et de comparaison comprenant deux entrées et deux sorties formant respectivement lesdites entrées (INN, INP) et lesdites sorties (OUTN, OUTP) de la cellule considérée, ainsi qu'une entrée de commande (SAMPLE) destinée à activer l'état d'échantillonnage de ladite cellule pendant ladite première phase (P1) de chaque cycle de conversion (CC1, CC2).

3. Convertisseur suivant la revendication 2, **caractérisé en ce que** lesdits moyens d'analyse et de commande (MAC) comprennent dans chacune desdites cellules des moyens logiques ($16_0$ à $16_{n-1}$) établissant une combinaison logique de type OU sur lesdites sorties (OUTN, OUTP) de la cellule considérée et fournissant, en fonction du résultat de cette combinaison, un signal de commande sur une sortie qui est raccordée à l'entrée de commande (SAMPLE) de la cellule de rang immédiatement inférieur à celui de la cellule considérée parmi lesdites n cellules, compté dans le sens du bit de poids le plus significatif (MSB) au bit de poids le plus faible (LSB).

4. Convertisseur suivant la revendication 2, **caractérisé en ce que** lesdits moyens d'analyse et de commande (MAC) comprennent, dans chacune desdites cellules, un circuit à retard connecté par son entrée à l'une des sorties de ladite cellule considérée et par sa sortie à l'entrée de commande de la cellule de rang immédiatement inférieur à celui de la cellule considérée parmi lesdites n cellules, compté dans le sens du bit de poids le plus significatif au bit de poids le moins significatif.

5. Convertisseur suivant l'une quelconque des revendications 3 et 4, **caractérisé en ce que** ledit registre de sortie présente au moins une entrée de commande et **en ce que** la sortie des moyens de combinaison logique ($16_0$ à $16_{n-1}$) de la cellule de rang le plus faible est connectée à ladite au moins une entrée de commande dudit registre de sortie (18) pour commander la délivrance en sortie dudit registre de sortie (18) du résultat de la conversion à l'achèvement d'un cycle de conversion (CC1, CC2).

6. Convertisseur suivant l'une quelconque des revendications précédentes, **caractérisé en ce que** lesdits moyens de ré-injection (14, 15) comprennent deux bancs de capacités dont les capacités ($C_{LSB}$ à $2^{n-1}C_{LSB}$) sont réparties à raison d'une capacité par cellule, l'une des armatures de chaque capacité étant respectivement reliée à l'un desdits noeuds d'entrée (6, 7) et l'autre armature étant connectée à l'une des sorties (OUTN, OUTP) de la cellule considérée.

7. Convertisseur suivant la revendication 6, **caractérisé en ce que**, pour pondérer ladite ré-injection, les valeurs des capacités ($C_{LSB}$ à $2^{n-1} C_{LSB}$) de chaque banc de capacités (14, 15) augmentent chaque fois d'un facteur 2, de la capacité de la cellule ($C_0$) de rang le plus faible parmi lesdites n cellules à la capacité de la cellule ($C_{n-1}$) de rang le plus élevé parmi lesdites n cellules

8. Convertisseur suivant la revendication 6, **caractérisé en ce que** chacun desdits bancs de capacités (14, 15) comprend également des capacités supplémentaires ($C_S$) raccordées respectivement entre chacun desdits noeuds d'entrée (6, 7) et la masse et **en ce que** la valeur totale des capacités de chaque banc de capacités ainsi agencé satisfait à la relation

$$C_{INN} = C_{INP} = C_S + \left(2^n - 1\right)C_{LSB}$$

dans laquelle :

- $C_{INN}$ et $C_{INP}$ sont respectivement les valeurs totales des capacités des deux bancs de capacités,
- $C_S$ est la valeur de la capacité supplémentaire,
- $C_{LSB}$ est la valeur de la capacité appartenant à la cellule de rang le plus faible parmi lesdites n cellules, et
- n est le nombre de cellules du convertisseur.

9. Convertisseur suivant l'une quelconque des revendications 2 à 8, **caractérisé en ce que** l'entrée de commande (SAMPLE) du circuit d'échantillonnage et de comparaison de la cellule ($C_{n-1}$) de rang le plus élevé parmi lesdites n cellules est connectée à une borne de déclenchement (17) sur laquelle peut être appliqué un signal de déclenchement (START) de chaque cycle de conversion (CC1, CC2).

10. Convertisseur suivant la revendication 9, **caractérisé en ce que** ladite borne de déclenchement (17) est également reliée à deux interrupteurs (12, 13) connectés respectivement auxdits noeuds d'entrée (6, 7) pour ne leur appliquer ledit signal analogique en mode différentiel que lorsque ledit signal de déclenchement (START) est actif.

11. Convertisseur suivant l'une quelconque des revendications 2 à 10, **caractérisé en ce que** ledit circuit d'échantillonnage et de comparaison comprend:

    - deux inverseurs rebouclés (21a, 21b) montés entre deux lignes de tension d'alimentation ($V_{DD}$, $V_{SS}$),
    - les entrées de déséquilibrage desdits deux inverseurs étant raccordées à une unité différentielle (27) comportant deux entrées destinées à recevoir lesdits signaux d'entrée (INN, INP) et dont les sorties sont reliées respectivement aux entrées de déséquilibrage desdits inverseurs (21a,21b), ladite unité différentielle (27) étant destinée à provoquer le basculement du circuit en faveur de l'un ou l'autre desdits inverseurs en fonction de la différence entre lesdits signaux d'entrée (INN, INP) constatée pendant ladite phase de comparaison (P1),
    - une unité de polarisation (26) pour polariser ladite unité différentielle (27) et
    - une unité de mise en court-circuit (25) activée, pendant ladite phase d'échantillonnage (P1) et sous la commande dudit signal de commande (SAMPLE) de manière à porter les sorties (OUTN, OUTP) desdits inverseurs à un même potentiel prédéterminé ($V_{SAMPLE}$) pour permettre l'échantillonnage desdits signaux d'entrée (INN, INP) au cours de ladite phase d'échantillonnage (P2).

12. Convertisseur selon la revendication 11, **caractérisé en ce que** chacun desdits inverseurs comprend deux transistors (ML2a, ML3a, ML2b, ML3b) d'un premier type de conductivité et un transistor (ML1a, ML1b) d'un deuxième type de conductivité assurée par des charges de signe opposé à celui des charges assurant la conductivité du premier type, les trajets drain-source de ces transistors étant connectés en série entre lesdites lignes de tension d'alimentation ($V_{DD}$, $V_{SS}$) et leurs grilles étant connectées ensemble, l'entrée de déséquilibrage de chaque inverseur étant formée par le noeud entre les trajets drain-source des transistors (ML2a, ML3a, ML2b, ML3b) de même type de conductivité et la sortie dudit circuit étant formée par le noeud entre les trajets source-drain des transistors (ML1a, ML1b) de conductivité opposée, ce même noeud étant raccordé à la grille du transistor de conductivité opposée de l'autre inverseur du circuit.

13. Convertisseur selon la revendication 12, **caractérisé en ce que** ladite unité différentielle (27) comprend deux transistors (MD1, MD2) du deuxième type de conductivité et dont les trajets source-drain sont raccordés entre ladite unité de polarisation (26) et les entrées de déséquilibrage respectives desdits inverseurs (21a, 21b).

14. Convertisseur selon l'une quelconque des revendications 11 à 13, **caractérisé en ce que** l'unité de polarisation (26), formée d'une ou de deux chaînes de transistors du deuxième type de conductivité, est agencée de telle sorte que le courant n'est établi que pendant la phase d'échantillonnage (P1), le courant établi dépendant dudit potentiel prédéterminé ($V_{SAMPLE}$).

15. Convertisseur selon l'une quelconque des revendications 11 à 13, **caractérisé en ce que** ladite unité de mise en court-circuit (25) est agencée pour, au cours de ladite phase d'échantillonnage (P1), connecter l'une à l'autre les sorties dudit circuit d'échantillonnage et de comparaison.

**Patentansprüche**

1. Analog-Digital-Wandler, dazu bestimmt, im Laufe von aufeinanderfolgenden Wandlungszyklen (CC1, CC2) ein analoges Eingangssignal in eine Folge von Binärwörtern umzuwandeln, von denen jedes n Bits umfasst, umfassend:

    - mindestens einen Eingangsknotenpunkt (6,7),

    - n Wandlerzellen ($C_0$ bis $C_{n-1}$),

    - ein Ausgangsregister (18), umfassend n Eingänge (D), von denen jeder an einen Ausgang von jeweils einer der genannten Zellen ($C_0$ bis $C_{n-1}$) und an die Ausgänge ($20_0$ bis $20_{n-1}$) angeschlossen ist, von dem die genannten Binärwörter bereit gestellt werden, und

    - Mittel zur Analyse und Steuerung (MAC), die auf die genannten n Zellen verteilt sind,

**dadurch gekennzeichnet, dass**

- das genannte analoge Eingangssignal im Differentialmodus in Form von zwei variablen Eingangssignalen auftritt ($V_{INN}$, $V_{INP}$),
- der genannte Analog-Digital-Wandler zwei Eingangsknotenpunkte (6,7) umfasst, an die im Laufe einer ersten Phase (P1) jedes Zyklus' (CC1, CC2) die jeweils zwei Eingangssignale angelegt werden,
- die genannten n Wandlerzellen jeweils zwei Eingänge (INN, INP) und zwei Ausgänge (OUTN, OUTP) umfassen,
- der genannte Analog-Digital-Wandler Mittel zur Reinjektion (14,15) umfasst, die auf die genannten n Zellen verteilt sind,

wobei die genannten Mittel zur Analyse und Steuerung (MAC) so ausgelegt sind, dass sie während der genannten ersten Phase (P1) nacheinander jede der genannten Zellen ($C_0$ bis $C_{n-1}$) aktivieren, um an den genannten Eingängen (INN, INP) die jeweils an den genannten Eingangsknotenpunkten (6,7) herrschenden Potentiale abzutasten und während einer zweiten Phase (P2) jedes Wandlungszyklus' (CC1, CC2) nacheinander die auf den genannten Eingangsknotenpunkten (6,7) herrschenden Potentiale vergleichen, wobei sie die genannten Zellen nacheinander deaktivieren, wobei die genannten Mittel zur Analyse und Steuerung (MAC) auch dafür ausgelegt sind, Logikniveaus zuzuweisen, die aus dem Vergleich resultieren und entgegengesetzten Binärwerten an den genannten Ausgängen (OUTN, OUTP) der genannten Zellen entsprechen, und

- die genannten Mittel zur Reinjektion (14,15) dafür ausgelegt sind, nach dem in jeder Zelle erfolgten Vergleich die genannten Logikniveaus der zwei Ausgänge dieser Zelle, die aus dem Vergleich in dieser Zelle resultieren, in die genannten Eingangsknotenpunkte (6,7) zu reinjizieren, wobei die Reinjektion entsprechend dem Rang (0 bis n-1) bemessen wird, die jede Zelle unter den genannten n Zellen einnimmt ($C_0$ bis $C_{n-1}$).

2. Wandler nach Anspruch 1, **dadurch gekennzeichnet, dass** die genannten Mittel zur Analyse und Steuerung (MAC) in jeder der genannten n Zellen ($C_0$ bis $C_{n-1}$) eine Abtast- und Vergleichsschaltung umfassen, die zwei Eingänge und zwei Ausgänge umfassen, die jeweils die zwei genannten Eingänge (INN, INP) und die genannten Ausgänge (OUTN, OUTP) der betrachteten Zelle bilden, ebenso wie einen Steuereingang (SAMPLE), der dazu bestimmt ist, den Abtastzustand der genannten Zelle während der genannten ersten Phase (P1) von jedem Wandlungszyklus (CC1, CC2) zu aktivieren.

3. Wandler nach Anspruch 2, **dadurch gekennzeichnet, dass** die genannten Mittel zur Analyse und Steuerung (MAC) in jeder der genannten Zellen Logikmittel ($16_0$ bis $16_{n-1}$ $_1$) umfassen, die eine Logikkombination des Typs ODER an den genannten Ausgängen (OUTN, OUTP) der betrachteten Zelle bilden und entsprechend dem Ergebnis dieser Kombination ein Steuersignal an einem Ausgang bereit stellen, der an den Steuereingang (SAMPLE) der Zelle angeschlossen ist, deren Rang unmittelbar niedriger ist als die der betrachteten Zelle unter den genannten n Zellen, gezählt von dem Bit mit der höchsten Wertigkeit (MSB) hin zu dem Bit mit der niedrigsten Wertigkeit (LSB).

4. Wandler nach Anspruch 2, **dadurch gekennzeichnet, dass** die genannten Mittel zur Analyse und Steuerung (MAC) in jeder der genannten Zellen eine Verzögerungsschaltung umfassen, die mit ihrem Eingang an einen der Ausgänge der genannten betrachteten Zelle und mit ihrem Ausgang an den Steuereingang der Zelle angeschlossen ist, deren Rang unmittelbar niedriger ist als die der betrachteten Zelle unter den genannten n Zellen, gezählt von dem Bit mit der höchsten Wertigkeit hin zu dem Bit mit der niedrigsten Wertigkeit.

5. Wandler nach einem der Ansprüche 3 und 4, **dadurch gekennzeichnet, dass** das genannte Ausgangsregister mindestens einen Steuereingang aufweist, und dadurch, dass der Ausgang der Logikkombinationsmittel ($16_0$ bis $16_{n-1}$) der Zelle mit dem niedrigsten Rang mit dem genannten mindestens einen Steuereingang des genannten Ausgangsregisters (18) angeschlossen ist, um die Freigabe des Ergebnisses der Wandlung nach Beendigung eines Wandlungszyklus' (CC1, CC2) am Ausgang des genannten Ausgangsregisters (18) zu steuern.

6. Wandler nach einem der vorhergehenden Ansprüche, **dadurch gekennzeichnet, dass** die genannten Mittel zur Reinjektion (14,15) zwei Kapazitätsbänke umfassen, deren Kapazitäten ($C_{LSB}$ bis $2^{n-1}C_{LSB}$) mit einer Kapazität pro Zelle verteilt sind, wobei einer der Anschlüsse jeder Kapazität jeweils mit einem der genannten Eingangsknotenpunkte (6,7) und der andere Anschluss mit einem der Ausgänge (OUTN, OUTP) der betrachteten Zelle verbunden ist.

7. Wandler nach Anspruch 6, **dadurch gekennzeichnet, dass**, um die genannte Reinjektion zu bemessen, die Werte der Kapazitäten ($C_{LSB}$ bis $2^{n-1}C_{LSB}$) jeder Kapazitätsbank (14,15) jedes Mal um einen Faktor 2 zunehmen, ausgehend von der Kapazität

der Zelle ($C_0$) mit dem niedrigsten Rang unter den genannten n Zellen bis hin zur Kapazität der Zelle ($C_{n-1}$) mit dem höchsten Rang unter den genannten n Zellen.

8.  Wandler nach Anspruch 6, **dadurch gekennzeichnet, dass** jede der genannten Kapazitätsbänke (14,15) auch zusätzliche Kapazitäten ($C_S$) umfasst, die jeweils zwischen jedem der genannten Eingangsknotenpunkten (6,7) und der Masse angeschlossen sind, und dadurch, dass der Gesamtwert der Kapazitäten jeder der dafür ausgelegten Kapazitätsbank dem Verhältnis

$$C_{INN} = C_{INP} = C_S + (2^n-1)C_{LSB}$$

entspricht, wobei:

-   $C_{INN}$ und $C_{INP}$ jeweils die Gesamtwerte der Kapazitäten der zwei Kapazitätsbänke sind,

-   $C_S$ der Wert der zusätzlichen Kapazität ist,

-   $C_{LSB}$ der Wert der Kapazität ist, die zu der Zelle mit der niedrigsten Rang unter den genannten n Zellen gehört, und

-   n die Anzahl der Zellen des Wandlers ist.

9.  Wandler nach einem der Ansprüche 2 bis 8, **dadurch gekennzeichnet, dass** der Steuereingang (SAMPLE) der Abtast- und Vergleichsschaltung der Zelle ($C_{n-1}$) mit dem höchsten Rang unter den genannten n Zellen an eine Auslöseklemme (17) angeschlossen ist, an die ein Auslösesignal (START) für jeden Wandlungszyklus (CC1, CC2) gelegt werden kann.

10. Wandler nach Anspruch 9, **dadurch gekennzeichnet, dass** die genannte Auslöseklemme (17) auch mit zwei Schaltern (12, 13) verbunden ist, die jeweils an die genannten Eingangsknotenpunkte (6, 7) angeschlossen sind, um das genannte analoge Signal im Differentialmodus erst dann an sie anzulegen, wenn das genannte Auslösesignal (START) aktiv ist.

11. Wandler nach einem der Ansprüche 2 bis 10, **dadurch gekennzeichnet, dass** die genannte Abtast- und Vergleichsschaltung umfasst:

-   zwei miteinander verbundene Wechselschalter (21a, 21b), die zwischen zwei Spannungsversorgungsleitungen eingebaut sind ($V_{DD}$, $V_{SS}$),

-   die Störeingänge der genannten zwei Wechselschalter, angeschlossen an eine Differentialeinheit (27), die zwei Eingänge aufweist, die dafür ausgelegt sind, die genannten Eingangssignale (INN, INP) zu empfangen und deren Ausgänge jeweils mit den Störeingängen der genannten Wechselschalter (21a, 21b) verbunden sind, wobei die genannte Differentialeinheit (27) dafür ausgelegt ist, das Kippen der Schaltung zugunsten des einen oder anderen Wechselschalters hervorzurufen, in Abhängigkeit von der Differenz zwischen den genannten Eingangssignalen (INN, INP), die während der genannten Vergleichsphase (P1) festgestellt wird,

-   eine Polarisationseinheit (26) zur Polarisierung der genannten Differentialeinheit (27) und

-   eine Einheit zum Kurzschließen (25), aktiviert während der genannten Abtastphase (P1) und unter Steuerung des genannten Steuersignals (SAMPLE) in der Weise, dass die Ausgänge (OUTN, OUTP) der genannten Wechselschalter auf ein zuvor festgelegtes gleiches Potential ($V_{SAMPLE}$) gebracht werden, um das Abtasten der genannten Eingangssignale (INN, INP) im Lauf der genannten Abtastphase (P2) zu erlauben.

12. Wandler nach Anspruch 11, **dadurch gekennzeichnet, dass** jeder der genannten Wechselschalter zwei Transistoren (ML2a, ML3a, ML2b, ML3b) eines ersten Leitfähigkeitstyps und einen Transistor (ML1a, ML1b) eines zweiten Leitfähigkeitstyps umfasst, dessen Leitfähigkeit durch Ladungen sichergestellt wird, deren Vorzeichen denen der Ladungen, die die Leitfähigkeit des ersten Typs sicherstellen, entgegengesetzt sind, wobei die Drain-Source-Strecken dieser Transistoren in Reihe zwischen den genannten Spannungsversorgungsleitungen ($V_{DD}$, $V_{SS}$) und ihre Gitter zusammen geschaltet sind, wobei der Störeingang jedes Wechselschalters von dem Knotenpunkt zwischen den Drain-Source-Strecken der Transistoren (ML2a, ML3a, ML2b, ML3b) desselben Leitfähigkeitstyps und der Ausgang der genannten Schaltung von dem Knotenpunkt zwischen den Drain-Source-Strecken der Transistoren (ML1a, ML1b) von entgegengesetzter Leitfähigkeit gebildet wird, wobei derselbe Knotenpunkt an das Gitter des Transistors mit entgegengesetzter Leitfähigkeit des anderen Wechselschalters der Schaltung angeschlossen ist.

13. Wandler nach Anspruch 12, **dadurch gekennzeichnet, dass** die genannte Differentialeinheit (27) zwei Transistoren (MD1, MD2) des zweiten Leitfähigkeitstyps umfasst, wobei deren Source-Drain-Strecken zwischen der genannten Polarisationseinheit (26) und den jeweiligen Störeingängen der genannten Wechselschalter (21a, 21b) angeschlossen sind.

14. Wandler nach einem der Ansprüche 11 bis 13, **dadurch gekennzeichnet, dass** die Polarisationseinheit (26), die durch ein oder zwei Transistorketten des zweiten Leitfähigkeitstyps gebildet wird, derart ausgelegt ist, dass der Strom erst während der Abtastphase (P1) eingeschaltet wird, wobei der eingeschaltete Strom von dem genannten zuvor festgelegten Potential ($V_{SAMPLE}$) abhängt.

15. Wandler nach einem der Ansprüche 11 bis 13, **dadurch gekennzeichnet, dass** die genannte Einheit zum Kurzschließen (25) so ausgelegt ist, dass sie im Lauf der genannten Abtastphase (P1) einen Eingang der genannten Abtast- und Vergleichsschaltung mit dem anderen verbindet.

**Claims**

1. Analog-to-digital converter adapted, during successive conversion cycles (CC1, CC2), to convert an analog input signal into a succession of binary words each comprising n bits, which converter comprises:

   - at least one input node (6, 7),
   - n conversion cells ($C_0$ to $C_{n-1}$),
   - an output register (18) having n inputs (D) each of which is connected to an output of a respective one of said cells ($C_0$ to $C_{n-1}$) and to the outputs ($20_0$ to $20_{n-1}$) at which said binary words are obtained, and
   - analysis and control means (MAC) distributed over said n cells,
     which converter is **characterized in that**:
   - said analog input signal is in differential mode and takes the form of two variable input signals ($V_{INN}$, $V_{INP}$),
   - said analog-to-digital converter has two input nodes (6, 7) to which the two input signals are respectively applied during a first phase (P1) of each cycle (CC1, CC2),
   - said n conversion cells each comprise two inputs (INN, INP) and two outputs (OUTN, OUTP),
   - said analog-to-digital converter comprises re-injection means (14, 15) distributed over said n cells,
   - said analysis and control means (MAC) are adapted, during said first phase (P1), to activate successively each of said cells ($C_0$ to $C_{n-1}$) in order to sample at said inputs (INN, INP) the potentials present at said input nodes (6, 7), respectively, and during a second phase (P2) of each conversion cycle (CC1, CC2), to compare successively the potentials at said input nodes (6, 7), whilst successively deactivating said cells, said analysis and control means (MAC) being also adapted to impose logic levels resulting from the comparison and corresponding to opposite binary values at said outputs (OUTN, OUTP) of said cells, and

   - said re-injection means (14, 15) are adapted, after the comparison effected in each cell, to re-inject into said input nodes (6, 7) said logic levels from the two outputs of that cell resulting from the comparison **in that** cell, the re-injection being weighted as a function of the rank (0 to n-1) occupied by each of said n cells ($C_0$ to $C_{n-1}$).

2. Converter according to claim 1, **characterized in that** said analysis and control means (MAC) comprise in each of said n cells ($C_0$ to $C_{n-1}$) a sampling and comparison circuit having two inputs and two outputs respectively forming said inputs (INN, INP) and said outputs (OUTN, OUTP) of the cell concerned and a control input (SAMPLE) for activating the sampling state of said cell during said first phase (P1) of each conversion cycle (CC1, CC2).

3. Converter according to claim 2, **characterized in that** said analysis and control means (MAC) comprise in each of said cells logic means ($16_0$ to $16_{n-1}$) for establishing an OR logic combination at said outputs (OUTN, OUTP) of the cell concerned and providing, as a function of the result of that combination, a control signal at an output that is connected to the control input (SAMPLE) of the cell of immediately next higher rank to the cell concerned from said n cells, counted in the direction from the most significant bit (MSB) to the least significant bit (LSB).

4. Converter according to claim 2, **characterized in that** said analysis and control means (MAC) comprise, in each of said cells, a delay circuit connected by its input to one of the outputs of said cell concerned and by its output to the control input of the cell of immediately lower rank than the cell concerned from said n cells, counting in the direction from the most significant bit to the least significant bit.

5. Converter according to either claim 3 or claim 4, **characterized in that** said output register has at least one control input and the output of the logic combination means ($16_0$ to $16_{n-1}$) of the cell of lowest rank is connected to said at least one control input of said output register (18) to control the delivery at the output of said output register (18) of the result of the conversion on completion of a conversion cycle (CC1, CC2).

**6.** Converter according to any preceding claim, **characterized in that** said re-injection means (14, 15) comprise two banks of capacitors ($C_{LSB}$ to $2^{n-1}C_{LSB}$) comprising one capacitor per cell, one side of each capacitor is connected to a respective one of said input nodes (6, 7) and the other side is connected to one of the outputs (OUTN, OUTP) of the cell concerned.

**7.** Converter according to claim 6, **characterized in that**, for weighting said re-injection, the values of the capacitors ($C_{LSB}$ to $2^{n-1}C_{LSB}$) of each bank of capacitors (14, 15) increase stepwise by a factor of 2 from the capacitor of the cell ($C_0$) of lowest rank of said n cells to the capacitor of the cell ($C_{n-1}$) of highest rank of said n cells.

**8.** Converter according to claim 6, **characterized in that** each of said banks of capacitors (14, 15) also comprises supplementary capacitors ($C_S$) respectively connected between each of said input nodes (6, 7) and ground and the total value of the capacitors of each bank of capacitors arranged in this way satisfies the equation:

$$C_{INN} = C_{INP} = C_S + (2^n - 1)C_{LSB}$$

in which:

- $C_{INN}$ and $C_{INP}$ are respectively the total values of the capacitors of the two banks of capacitors,
- $C_S$ is the value of the supplementary capacitor,
- $C_{LSB}$ is the value of the capacitor of the cell of lowest rank of said n cells, and
- n is the number of cells of the converter.

**9.** Converter according to any one of claims 2 to 8, **characterized in that** the control input (SAMPLE) of the sampling and comparison circuit of the cell ($C_{n-1}$) of the highest rank from said n cells is connected to a triggering terminal (17) to which may be applied a signal (START) for triggering each conversion cycle (CC1, CC2).

**10.** Converter according to claim 9, **characterized in that** said triggering terminal (17) is also connected to two switches (12, 13) respectively connected to said input nodes (6, 7) to apply said differential mode analog signal to them only if said triggering signal (START) is active.

**11.** Converter according to any one of claims 2 to 10, **characterized in that** said sampling and comparison circuit comprises:

- two looped inverters (21 a, 21 b) disposed between two supply voltage lines ($V_{DD}$, $V_{SS}$),

- the imbalance inputs of said two inverters being connected to a differential unit (27) having two inputs adapted to receive said input signals (INN, INP) and whose outputs are respectively connected to the imbalance inputs of said inverters (21a, 21b), said differential unit (27) being adapted to cause a change of state of the circuit in favor of one or the other of said inverters as a function of the difference between said input signals (INN, INP) during said comparison phase (P1),
- a biasing unit (26) for biasing said differential unit (27), and
- a short circuiting unit (25) adapted to be activated during said sampling phase (P1) and under the control of said control signal (SAMPLE) to apply to the outputs (OUTN, OUTP) of said inverters the same predetermined potential ($V_{SAMPLE}$) for sampling said input signals (INN, INP) during said sampling phase (P2).

**12.** Converter according to claim 11, **characterized in that** each of said inverters comprises two transistors (ML2a, ML3a, ML3b, ML3b) of a first conductivity type and a transistor (ML1a, ML1b) of a second conductivity type provided by charges of opposite sign to the charges providing the conductivity of the first type, the drain-source paths of these transistors are connected in series between said supply voltage lines ($V_{DD}$, $V_{SS}$) and their gates are connected together, the imbalance input of each inverter is formed by the node between the drain-source paths of the transistors (ML2a, ML3a, ML2b, ML3b) of the same conductivity type, the output of said circuit is formed by the node between the source-drain paths of the transistors (ML1a, ML1b) of opposite conductivity, and this same node is connected to the gate of the transistor of opposite conductivity of the other inverter of the circuit.

**13.** Converter according to claim 12, **characterized in that** said differential unit (27) comprises two transistors (MD1, MD2) with the second conductivity type and whose source-drain paths are connected between said bias unit (26) and the respective imbalance inputs of said inverters (21a, 21 b).

**14.** Converter according to any one of claims 11 to 13, **characterized in that** the bias unit (26) is formed of one or two chains of transistors of the second conductivity type and is adapted so that the current is established only during the sampling phase (P1), the current established depending on said predetermined potential ($V_{SAMPLE}$).

**15.** Converter according to any one of claims 11 to 13, **characterized in that** said short circuiting unit (25) is adapted to connect the outputs of said sampling and comparison circuit to each other during said sampling phase (P1).

FIG.: 1

FIG.2

FIG.3

FIG.4

FIG.5